# EUROPÄISCHE PATENTSCHRIFT

(11) **EP 2 254 215 B1**
(45) Veröffentlichungstag und Bekanntmachung des Hinweises auf die Patenterteilung: **08.06.2016**
(21) Anmeldenummer: 09005878.5
(22) Anmeldetag: 28.04.2009
(51) Int. Cl.: H02H 3/087, H03K 17/082, H02H 1/00, H02H 5/04, H03K 17/08

(54) **Schaltungsanordnung**
Circuit arrangement
Agencement de circuit

(43) Veröffentlichungstag der Anmeldung: 24.11.2010
(73) Patentinhaber: Delphi International Operations Luxembourg S.à r.l., 4940 Bascharage (LU)
(72) Erfinder: Heinrich, Markus, 51588 Nümbrecht (DE)
(74) Vertreter: Delphi France SAS

(56) Entgegenhaltungen:
- EP-A- 0 167 884
- DE-A1- 3 725 390
- DE-A1-102005 046 979
- US-A- 5 898 557
- US-A1- 2006 164 772
- US-A1- 2007 008 672

## Beschreibung

Die Erfindung betrifft eine Schaltungsanordnung mit wenigstens einem auf einer Leiterplatte angeordneten Leistungsschalter, der an eine Last anschließbar ist, einem Senseelement, durch das ein vom durch die Last fließenden Laststrom abhängiger Sensestrom fließt, der einem kleineren Teil des Laststromes entspricht, und einer Steuer- und/oder Auswerteeinrichtung zur Erfassung des Sensestromes und zur Ermittlung des Laststromes des Leistungsschalters in Abhängigkeit vom erfassten Sensestrom, wobei eine einen Leiterbahnabschnitt der Leiterplatte umfassende Sensezone vorgesehen ist, durch die der Laststrom fließt, und der durch das Senseelement fließende Strom mittels der Steuer- und/oder Auswerteeinrichtung auf einen Wert geregelt wird, der in einem vorgebbaren Verhältnis zu dem in der Sensezone fließenden Strom steht.

Eine Schaltungsanordnung dieser Art ist in der US 2006/164772 A1 beschrieben.

Der elektrische Zustand eines Halbleiter-Leistungsschalters lässt sich durch Messung des durch diesen fließenden Laststroms charakterisieren. Dabei kann der Leistungsschalter im Fall der Detektion eines zu hohen Laststroms beispielsweise automatisch abgeschaltet werden. Durch die entsprechende Unterbrechung des Laststroms wird sowohl der Leistungsschalter als auch die angeschlossene Last vor unzulässigen Überströmen geschützt.

Die Ermittlung des Laststroms in Abhängigkeit von dem durch ein Senseelement, insbesondere Sensewiderstand, fließenden Sensestrom, der einem Bruchteil des Laststroms entspricht, bringt unter anderem den Vorteil einer Verringerung der bei der Strommessung auftretenden Verlustenergie mit sich.

Bei den bisher üblichen Stromsensierungskonzepten und Schaltungsanordnungen der eingangs genannten Art wurde der Halbleiter-Leistungsschalter in einen flächenmäßig kleineren Teil und einen flä-chenmäßig größeren Teil aufgeteilt, wobei der flächenmäßig kleinere Teil eine Sensezelle und der flächenmäßig größere Teil eine Hauptzelle des Leistungsschalters bildeten.

Entsprechende Leistungsschalter mit integrierter Sensezelle wie beispielsweise so genannte SenseFETs sind jedoch relativ aufwendig und entsprechend teuer.

Der Erfindung liegt die Aufgabe zugrunde, eine verbesserte Schaltungsanordnung der eingangs genannten Art zu schaffen, mit der eine zuverlässige Messung des Laststroms und ein vollständiger Schutz des Leistungsschalters auch ohne in diesem integrierte Sensezelle und integrierte Temperaturdiode möglich ist.

Diese Aufgabe wird erfindungsgemäß dadurch gelöst, dass die Steuer- und/oder Auswerteeinrichtung den Laststrom anhand des erfassten Sensestromes und eines Skalierungsfaktors ermittelt, der durch das Verhältnis des Widerstandes des Senseelements zum Widerstand der Sensezone, vorzugsweise zum Widerstand der Sensezone bei einer vorgebbaren Temperatur, bestimmt ist, und dass die Steuer- und/oder Auswerteeinrichtung Mittel umfasst, um bei der Ermittlung des Laststromes sich aufgrund von Temperaturänderungen, insbesondere Temperaturänderungen gegenüber der vorgebbaren Temperatur, ergebende Änderungen des Skalierungsfaktors zu kompensieren.

Aufgrund dieser Ausbildung sind keine aufwendigen und entsprechend teuren Leistungsschalter mit integrierter Sensezelle bzw. SenseFETs mehr zur Messung des Laststroms erforderlich. Es können durchgehend kostengünstigere herkömmliche Leistungsschalter eingesetzt werden.

Bei dem Leistungsschalter kann es sich beispielsweise um einen FET (Feldeffekttransistor), insbesondere MOSFET (Metall-Oxid-Halbleiter-Feldeffekttransistor) handeln. Grundsätzlich kommen jedoch auch beliebige andere Halbleiter-Leistungsschalter wie beispielsweise Bipolartransistoren und IGBTs (insulated gate bipolar transistor) in Betracht.

Das Senseelement kann insbesondere einen Sensewiderstand umfassen.

Gemäß einer bevorzugten praktischen Ausführungsform der erfindungsgemäßen Schaltungsanordnung wird die am Senseelement abfallende Spannung mittels der Steuer- und/oder Auswerteeinrichtung auf einen Wert geregelt, der der an der Sensezone abfallenden Spannung entspricht.

Bevorzugt sind Mittel vorgesehen, die die Temperaturabhängigkeit des Messsystems zentral kompensieren. Dabei kann je ein Temperatursensor die Temperatur des Leistungsschalters auf der Leiterplatte erfassen.

Indem die Steuer- und/oder Auswerteeinrichtung Mittel umfasst, um bei der Ermittlung des Laststromes sich aufgrund von Temperaturänderungen, insbesondere Temperaturänderungen gegenüber der vorgebbaren Temperatur, ergebende Änderungen des Skalierungsfaktors zu kompensieren, wird insbesondere dem Umstand Rechnung getragen, dass der Widerstandswert des in der Regel aus Kupfer bestehenden, die Sensezone bildenden Leiterbahnabschnitts der Leiterplatte temperaturabhängig ist. Dagegen ist der Widerstandswert des Senseelements bzw. Sensewiderstands in der Regel zumindest im Wesentlichen temperaturunabhängig.

Die Mittel zur Kompensation von sich aufgrund von Temperaturänderungen ergebenden Änderungen des Skalierungsfaktors können beispielsweise einen NTC (negative temperature coefficient)-Widerstand umfassen.

Das Senseelement umfasst vorteilhafterweise einen SMD (surface mounted device)-Sensewiderstand.

Gemäß einer zweckmäßigen praktischen Ausführungsform der erfindungsgemäßen Schaltungsanordnung umfasst die Steuer- und/oder Auswerteeinrichtung zur Erfassung des Sensestromes und zur Regelung der am Senseelement abfallenden Spannung einen Differenzverstärker, vorzugsweise Operationsverstärker.

Zur Ermittlung des Laststromes in Abhängigkeit vom erfassten Sensestrom umfasst die Steuer- und/oder Auswerteeinrichtung vorteilhafterweise einen Analog/Digital-Wandler und eine Logikschaltung.

Dabei können vorteilhafterweise mehreren Leistungsschaltern ein gemeinsamer Analog/Digital-Wandler und eine gemeinsame Logikschaltung und vorzugsweise gemeinsame Mittel zur Kompensation von sich aufgrund von Temperaturänderungen ergebenden Änderungen des Skalierungsfaktors zugeordnet sein. Zur Temperaturkompensation ist also u.a. beispielsweise nur ein einziger NTC-Widerstand für mehrere Leistungsschalter erforderlich.

Eine weitere bevorzugte Ausführungsform zeichnet sich dadurch aus, dass die Sensezonen in den Innenlagen der Leiterplatte dicht beieinander liegen, dass die Sensezonen in den Außenlagen der Leiterplatte von insbesondere je zwei Kupferflächen überdeckt sind, dass die oberen und unteren Kupferflächen mit Thermo Vias verbunden sind und dass der temperaturabhängige NTC-Widerstand der Mittel zur Temperaturkompensation auf jeweils eine Kupferfläche aufgelötet ist.

Die Steuer- und/oder Auswerteeinrichtung umfasst für jeden Leistungsschalter bevorzugt jeweils einen getrennten Differenzverstärker. Die verschiedenen Differenzverstärker können dann insbesondere über einen Multiplexer mit dem gemeinsamen Analog/Digital-Wandler verbunden sein. Es sind in diesem Fall also mehrere Differenzverstärker vorgesehen, während lediglich ein einziger Multiplexer und lediglich ein einziger Analog/Digital-Wandler genügen.

Eine bevorzugte praktische Ausführungsform der erfindungsgemäßen Schaltungsanordnung zeichnet sich dadurch aus, dass der Hauptstrompfad des Leistungsschalters, die Sensezone und die Last in Reihe zwischen zwei Versorgungsspannungsklemmen geschaltet sind, dass das Senseelement einerseits mit dem höheren Potential der Sensezone und andererseits mit einem ersten Eingang des zugeordneten Differenzverstärkers verbunden ist und dass das niedrigere Potential der Sensezone mit einem zweiten Eingang des Differenzverstärkers verbunden ist. Dabei kann der Leistungsschalter oberhalb oder auch unterhalb der Sensezone angeordnet sein.

Wie bereits erwähnt, können insbesondere auch Mittel zur Überwachung der im Bereich des Leistungsschalters vorherrschenden Temperatur vorgesehen sein. Bevorzugt umfassen die Temperaturüberwachungsmittel einen NTC-Widerstand, der in unmittelbarer Nähe des Leistungsschalters positioniert ist. Das Gehäuse des Leistungsschalters besitzt vorteilhafterweise einen möglichst kleinen thermischen Widerstand zur Leiterplatte, so wie es beispielsweise bei einem so genannten D-Pack-Gehäuse der Fall ist.

Der NTC-Widerstand sollte thermisch gut leitend am Leistungsschalter angeschlossen sein. Dies kann im Layout des Leiterplattendesigns z.B. dadurch berücksichtigt werden, dass in der Innenlage Kupferflächen unterhalb des Leistungsschalters verlaufen, die mit dem NTC-Widerstand elektrisch verbunden sind. Die Lötstellen des NTC-Widerstandes können ihrerseits mit so genannten "Thermo Vias" mit den Flächen verbunden sein.

Von Vorteil ist insbesondere auch, wenn ein NTC-Widerstand zur Erfassung der umgebenden Temperatur des Leistungsschalters sehr nahe am Leistungsschalter positioniert ist, der über zwei Kupferflächen gelötet ist, die in der angrenzenden Innenlage unterhalb des Leistungsschalters und/oder unterhalb des NTC-Widerstandes verlaufen können, und wenn der NTC-Widerstand über Thermo Vias mit den Kupferflächen elektrisch verbunden ist.

Bevorzugt sind Mittel vorgesehen, um den Leistungsschalter abzuschalten, wenn der Laststrom einen vorgebbaren maximal zulässigen Stromwert überschreitet und/oder die im Bereich des Leistungsschalters vorherrschende Temperatur einen vorgebbaren maximal zulässigen Temperaturwert überschreitet und/oder der Laststrom einen vorgebbaren, im Vergleich zum maximalen Stromwert kleineren Stromwert für eine vorgebbare Zeit überschreitet.

Der Leistungsschalter umfasst bevorzugt einen FET, insbesondere einen MOSFET. Wie bereits erwähnt, kann es sich bei dem Leistungsschalter jedoch auch um einen beliebigen anderen Halbleiter-Leistungsschalter handeln.

Zur Kompensation von sich aufgrund von Temperaturänderungen ergebenden Änderungen des Skalierungsfaktors könnte grundsätzlich über die Steuer- und/oder Auswerteeinrichtung bzw. einen dieser zugeordneten Mikrocontroller oder eine entsprechende integrierte Schaltung die Temperaturabweichung gegenüber der vorgebbaren Temperatur gemessen werden, auf die die Schaltungsanordnung bzw. die Steuer- und/oder Auswerteeinrichtung vorzugsweise geeicht ist.

Es wäre beispielsweise auch denkbar, einen Sensewiderstand zu verwenden, der die gleiche Temperaturabhängigkeit wie der die Sensezone bildende Leiterbahnabschnitt der Leiterplatte besitzt. Ein Sensewiderstand entsprechender Temperaturabhängigkeit wäre jedoch relativ teuer.

Bevorzugt umfassen die betreffenden Kompensationsmittel daher Mittel zur Erzeugung eines beispielsweise von der Sensezonentemperatur abhängigen Referenzstroms, die insbesondere einen NTC-Widerstand oder dergleichen umfassen können. Dabei genügt beispielsweise ein NTC-Widerstand für alle Kanäle bzw. Leistungsschalter, da eventuelle Fehler aufgrund unterschiedlicher Entfernungen der Sensezone zu dem betreffenden, beispielsweise einen NTC-Widerstand umfassenden Sensor vernachlässigbar gering sind, vorausgesetzt im Layout und in der Schaltungsdimensionierung werden die folgenden zwei Faktoren beachtet: die entstehende Verlustleistung der Sensezonen sollte keine zu große Temperaturerhöhung erzeugen. Der Widerstand der Sensezonen muss also entsprechend dimensioniert werden. Zum anderen werden beim Vorhandensein mehrerer Sensezonen diese untereinander thermisch gekoppelt. Bevorzugt wird dies erreicht, indem die in den Innenlagen verlaufenden Kupferbahnen parallel verlaufen und beieinander liegen.

Zwischen den Bahnen werden bevorzugt kleine "Thermo Vias" berücksichtigt, die ihrerseits mit je zwei gleich großen Kupferflächen verbunden werden, die oberhalb und unterhalb der Sensezonen auf separaten Lagen verlaufen. Der NTC-Widerstand wird in einer Außenlage mittig auf zwei der vier Kupferflächen platziert, so dass die Flächen thermisch und elektrisch mit dem NTC-Widerstand verbunden sind. Die Sensezonenfläche sollte möglichst klein sein, damit die Wege zum Temperatursensor kurz bleiben. Daher kann es gegebenenfalls sinnvoll sein, die Sensezonen übereinander auf zwei Innenlagen zu verteilen.

Die betreffende Temperaturkompensation kann insbesondere über den Strombezugswert der Strommessschaltung der Steuer- und/oder Auswerteeinrichtung erfolgen, wobei z.B. ein zu einem Widerstand paralleler NTC-Widerstand und ein dazu in Reihe geschalteter Serienwiderstand zur Linearisierung und Anpassung der Temperaturabhängigkeit des betreffenden Leiterbahnabschnitts der Leiterplatte vorgesehen sein können.

Der Skalierungsfaktor kann beispielsweise durch Auswahl eines anderen Senseelements bzw. Sensewiderstandes und/oder durch eine Änderung der Leiterplatten-Auslegung variabel eingestellt werden, solange der für die Messung berechnete Strom fließt. Im Fehlerfall muss die Auswerteschaltung bei überschreiten definierter Stromgrenzwerte und Reaktionszeiten abschalten.

Angesichts der großen Fläche der Leiterplatte und des kleinen Leiterplatten-Widerstandes ergibt sich allenfalls eine geringe Verlustleistung, so dass insoweit keine thermischen Probleme auftreten, solange der für die Messung berechnete Strom fließt. Im Fehlerfall muss die Auswerteschaltung bei Überschreiten definierter Stromgrenzwerte und Reaktionszeiten abschalten.

Bevorzugt ist die einen Leiterbahnabschnitt der Leiterplatte umfassende Sensezone durch einen entsprechenden Abschnitt einer Innenschicht der Leiterplatte gebildet. Auch bei unterschiedlichen Dicken der Leiterplatte ändert sich die Dicke dieser Innenschicht um etwa 10 %, so dass auch insoweit eventuell auftretende Fehler der Messung tolerierbar sind. Erforderlichenfalls kann der Prozess der Herstellung der Leiterplatte im Hinblick auf die Anforderungen an die Laststrommessung optimiert werden. Ein eventueller Fehler infolge des Abstandes des Temperatursensors bzw. NTC-Widerstandes zu den verschiedenen Sensezonen bzw. Leiterbahnabschnitten oder Shunts ist zumindest bei einer Temperaturdifferenz zwischen Shunt und Temperatursensor von etwa 10°C vernachlässigbar, wobei selbst eine Temperaturdifferenz von etwa 20°C noch akzeptabel wäre. Wie bereits erwähnt kann insbesondere durch ein entsprechendes Layout dafür gesorgt werden, dass der Temperatursensor und die Sensezonen möglichst nahe zusammen liegen. Selbst bei größeren Fehlern bezüglich des Skalierungsfaktors ist es möglich, den Skalierungsfaktor bei Endkontrollen zu messen. Der individuelle Skalierungsfaktor kann in einem Speicher der Steuer- und/oder Auswerteeinrichtung oder einem dieser zugeordneten Mikrocontroller gespeichert werden, so dass beispielsweise über eine entsprechende Programmierung der Steuer- und/oder Auswerteeinrichtung der Fehler über diese Steuer- und/oder Auswerteeinrichtung minimiert werden kann.

Die Erfindung wird im Folgenden anhand von Ausführungsbeispielen unter Bezugnahme auf die Zeichnung näher erläutert; in dieser zeigen:
- Fig. 1: eine schematische Darstellung einer beispielhaften Ausführungsform der erfindungsgemäßen Schaltungsanordnung mit mehreren Leistungsschaltern und zusätzlichen Mitteln zur Temperaturüberwachung,
- Fig. 2: eine perspektivische Darstellung des eine Sensezone bildenden Leiterbahnabschnitts der Leiterplatte,
- Fig. 3: eine schematische Prinzipdarstellung einer beispielhaften Ausführungsform der erfindungsgemäßen Schaltungsanordnung mit mehreren Leistungsschaltern, einer eine entsprechende Anzahl von Anwendungsspezifischen Integrierten Schaltungen (ASICs) umfassenden Steuer- und/oder Auswerteeinrichtung und einem Mikrocontroller und
- Fig. 4: ein Schaltbild eines einen NTC-Widerstand umfassenden beispielhaften Schaltkreises zur Erzeugung eines Referenzstromes zur Temperaturkompensation.

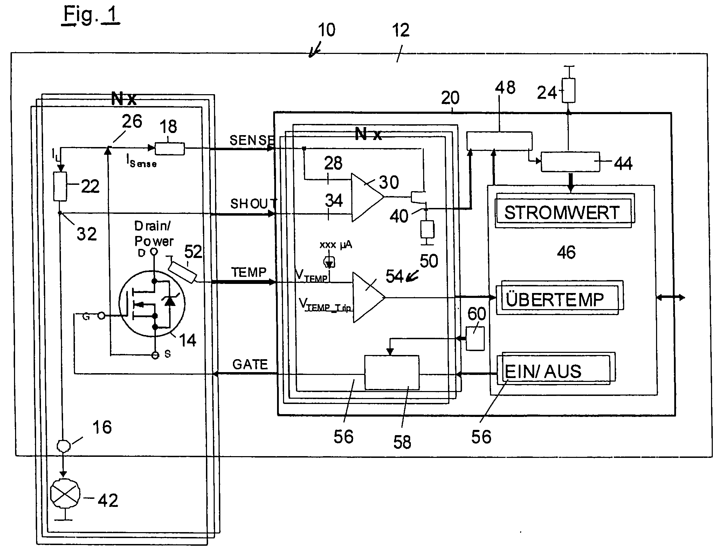

Fig. 1 zeigt in schematischer Darstellung eine beispielhafte Ausführungsform einer Schaltungsanordnung 10 mit wenigstens einem auf einer Leiterplatte 12 angeordneten Leistungsschalter 14, der beispielsweise über einen Anschluss oder Laststecker 16 an eine Last 42 anschließbar ist, und einem Senseelement 18, bei dem es sich insbesondere um einen Sensewiderstand handeln kann und durch das ein vom durch die Last 42 fließenden Laststrom I_{L} abhängiger Sensestrom I_{Sense} fließt, der einem kleineren Teil des Laststroms I_{L} entspricht. Sie umfasst ferner eine Steuer- und/oder Auswerteeinrichtung 20 zur Erfassung des Sensestromes I_{Sense} und zur Ermittlung des Laststroms I_{L} des Leistungsschalters 14 in Abhängigkeit vom erfassten Sensestrom I_{Sense}.

Zudem umfasst die Schaltungsanordnung 10 eine durch einen Leiterbahnabschnitt der Leiterplatte 12 gebildete Sensezone oder Shunt 22, durch die bzw. den der Laststrom I_{L} fließt. Dabei ist die Steuer- und/oder Auswerteeinrichtung 20 so ausgeführt, dass der durch das Senseelement 18 fließende Strom auf einen Wert geregelt wird, der in einem vorgebbaren Verhältnis zu dem in der Sensezone 22 fließenden Strom steht.

Dabei kann die am Senseelement 18 abfallende Spannung mittels der Steuer- und/oder Auswerteeinrichtung 20 insbesondere auf einen Wert geregelt werden, der der an der Sensezone 22 abfallenden Spannung entspricht.

Die Steuer- und/oder Auswerteeinrichtung 20 kann insbesondere so ausgeführt sein, dass sie den Laststrom I_{L} anhand des erfassten Sensestromes I_{Sense} und eines Skalierungsfaktors ermittelt, der durch das Verhältnis des Widerstands des Senseelements 18 zum Widerstand der Sensezone 22, vorzugsweise zum Widerstand der Sensezone 22 bei einer vorgebbaren Temperatur, bestimmt ist.

Die Steuer- und/oder Auswerteeinrichtung 20 kann insbesondere auch Mittel 24 umfassen, um bei der Ermittlung des Laststroms I_{L} sich aufgrund von Temperaturänderungen, insbesondere Temperaturänderungen gegenüber der vorgebbaren Temperatur, ergebende Änderungen des Skalierungsfaktors zu kompensieren. Dabei können diese Mittel 24 zur Kompensation von sich aufgrund von Temperaturänderungen ergebenden Änderungen des Skalierungsfaktors insbesondere einen NTC-Widerstand umfassen.

Das Senseelement 18 kann insbesondere durch einen SMD-Sensewiderstand gebildet sein. Im Betrieb können der Hauptstrompfad des Leistungsschalters 14, die Sensezone 22 und die beispielsweise über den Anschluss 16 zugeschaltete Last 42 insbesondere in Reihe zwischen zwei Versorgungsspannungsklemmen geschaltet sein.

Wie sich aus der Fig. 1 ergibt, kann das Senseelement 22 an dem höheren Potential 26 der Sensezone 22 einerseits und andererseits mit einem ersten Eingang 28 des Differenzverstärkers 30 verbunden sein, während das niedrigere Potential 32 der Sensezone 22 mit einem zweiten Eingang 34 des Differenzverstärkers 30 verbunden sein kann.

Prinzipiell kann die Sensezone 22 wie in Fig. 1 gezeigt sowohl unterhalb des Leistungsschalters 14 in Reihe angeschlossen sein, als auch oberhalb.

Über eine Rückkopplung kann das Potential am ersten Eingang des Differenz- bzw. Operationsverstärkers 30 auf das Potential das zweiten Eingangs 34 geregelt werden, was bedeutet, dass die Spannung zwischen den beiden Eingängen 28, 34 des Differenz- bzw. Operationsverstärkers 30 null wird, so dass die am Senseelement 18 abfallende Spannung auf einen Wert geregelt wird, der der an der Sensezone abfallenden Spannung entspricht. An seinem Ausgang 40 liefert der Differenzverstärker 30 ein zum Sensestrom I_{Sense} repräsentatives Signal.

Zudem kann die Steuer- und/oder Auswerteeinrichtung 20 zur Ermittlung des Laststroms I_{L} in Abhängigkeit vom erfassten Sensestrom I_{Sense} einen Analog/Digital-Wandler 44 und eine Logikschaltung 46 umfassen.

Dabei können mehreren Leistungsschaltern 14, hier beispielsweise den N Leistungsschaltern 14, ein gemeinsamer Analog/Digital-Wandler 44 und eine gemeinsame Logikschaltung 46 und vorzugsweise gemeinsame Mittel 24 zur Kompensation von sich aufgrund von Temperaturänderungen ergebenden Änderungen des Skalierungsfaktors zugeordnet sein.

Dagegen umfasst die Steuer- und/oder Auswerteeinrichtung 20 für jeden Leistungsschalter 14 vorzugsweise jeweils einen getrennten Differenz- bzw. Operationsverstärker 30, wobei im vorliegenden Fall insbesondere N solche Verstärker 30 vorgesehen sein können.

Wie anhand der Fig. 1 zu erkennen ist, können die verschiedenen Leistungsschaltern 14 zugeordneten Differenzverstärker 30 beispielsweise über einen Multiplexer 48 mit dem gemeinsamen Analog/Digital-Wandler 44 verbunden sein. Es ist also insbesondere auch nur ein solcher Multiplexer 48 für die N Leistungsschalter 14 erforderlich.

Überdies können Mittel 50 zur Überwachung der im Bereich der Leistungsschalter 14 vorherrschenden Temperatur vorgesehen sein. Wie sich aus Fig. 1 ergibt, können diese Temperaturüberwachungsmittel beispielsweise für jeden Leistungsschalter 14 einen insbesondere in dessen Nähe angeordneten NTC-Widerstand 52 und einen insbesondere der Steuer- und/oder Auswerteeinrichtung 20 zugeordneten Komparator 54 umfassen, der ein über den NTC-Widerstand 52 gewonnenes, für die jeweilige Temperatur repräsentative Spannung V_{TEMP} mit einem Abschaltpegel V_{TEMP_TRIP} vergleicht, um bei Überschreiten dieses Pegels bzw. einer entsprechenden vorgebbaren maximal zulässigen Temperatur ein entsprechendes Signal beispielsweise an die Logikschaltung 46 zu liefern, in der dann eine entsprechende Übertemperatur detektiert wird. Dabei kann beispielsweise wieder für jeden Leistungsschalter 14 ein getrennter Komparator 54 vorgesehen sein.

Zudem können insbesondere wieder der Steuer- und/oder Auswerteeinrichtung zugeordnete Mittel 56 vorgesehen sein, um die Leistungsschalter 14 jeweils abzuschalten, wenn der Laststrom I_{L} einen vorgebbaren maximal zulässigen Stromwert und/oder die im Bereich eines jeweiligen Leistungsschalters 14 vorherrschende Temperatur einen vorgebbaren maximal zulässigen Temperaturwert überschreitet.

Die Steuer- bzw. Gate-Elektrode eines jeweiligen Leistungsschalters 14 kann beispielsweise über einen jeweiligen Treiber 58 angesteuert sein, der insbesondere wieder der Steuer- und/oder Auswerteeinrichtung 20 zugeordnet sein kann. Im vorliegenden Fall können beispielsweise wieder N solche Treiber 58 vorgesehen sein. Einem jeweiligen Treiber 58 kann beispielsweise eine Ladungspumpe 60 zugeordnet sein. Die Treiber 58 selbst können beispielsweise wieder über die Logikschaltung 46 angesteuert sein.

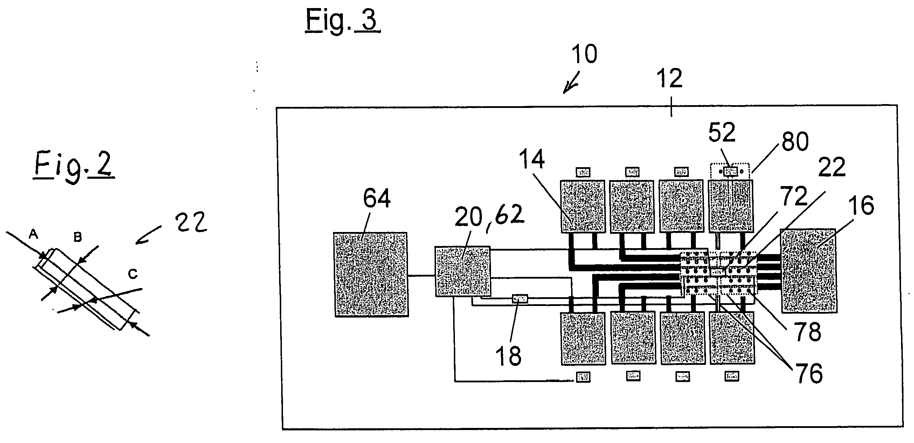

Fig. 2 zeigt den die Sensezone oder Shunt 22 bildenden Leiterbahnabschnitt der Leiterplatte 12 in perspektivischer Darstellung. Dabei ist mit "A" die Länge, mit "B" die Breite und mit "C" die Dicke dieses Leiterbahnabschnitts bezeichnet.

Die Sensezone 22 sollte vorzugsweise in der Innenlage der Leiterplatte vorgesehen werden, da das Kupfer der Innenlagen aus Kupferfolien besteht, deren Kupferstärke kleiner toleriert ist als dies auf den Außenlagen der Fall ist, da diese in einem galvanischen Prozess mit zusätzlichem Kupfer versehen werden.

Bei dem Leistungsschalter 14 handelt es sich im vorliegenden Fall beispielsweise um einen FET-Transistor. Dabei kann beispielsweise, wie aus der Fig. 1 ersichtlich, der Source-Anschluss dieses FET-Transistors mit dem dem Senseelement 18 zugewandten Ende der Sensezone 22 verbunden sein.

Wie eingangs bereits erwähnt, kann der Leistungsschalter 14 grundsätzlich auch einen beliebigen anderen Halbleiter-Leistungsschalter umfassen.

Fig. 1 zeigt in schematischer Darstellung eine beispielhafte Ausführungsform der Schaltungsanordnung 10 mit mehreren Leistungsschaltern 14, bei denen es sich beispielsweise jeweils wieder um einen FET-Transistor oder einen beliebigen anderen Halbleiter-Leistungsschalter handeln kann. Dabei sind im vorliegenden Fall beispielsweise N solche Leistungsschalter 14 vorgesehen.

Wie bereits erwähnt und aus der Fig. 1 ersichtlich, kann die Steuer- und/oder Auswerteeinrichtung 20 zur Erfassung des Sensestromes I_{Sense} und zur Regelung der an einem jeweiligen Leistungsschalter 14 zugeordneten Senseelement 18 abfallenden Spannung jeweils einen Differenzverstärker 30, vorzugsweise Operationsverstärker, umfassen.

Wie auch aus der Fig. 1 nochmals ersichtlich, kann der Hauptstrompfad eines jeweiligen Leistungsschalters 14, die zugeordnete Sensezone 22 und die jeweilige Last 42 in Reihe zwischen zwei Versorgungsspannungsklemmen geschaltet sein. Zudem kann die Beschaltung beispielsweise jeweils wieder so vorgesehen sein, dass das Senseelement 18 einerseits mit dem höheren Potential der Sensezone 22 an dem Knotenpunkt 26 und andererseits mit einem ersten Eingang 28 des zugeordneten Differenzverstärkers 30 verbunden sein, während andererseits das niedrigere Potential der Sensezone 22 am Knotenpunkt 32 mit einem zweiten Eingang 34 des Differenzverstärkers 30 verbunden ist.

Fig. 3 zeigt in schematischer Prinzipdarstellung nochmals eine beispielhafte Ausführungsform der erfindungsgemäßen Schaltungsanordnung 10 mit mehreren Leistungsschaltern 14, einer eine entsprechenden Anzahl von Anwendungsspezifischen Integrierten Schaltungen (ASICs) 62 umfassenden Steuer- und/oder Auswerteeinrichtung 20 sowie einem Mikrocontroller 64. Dabei sind im vorliegenden Fall beispielsweise acht Leistungsschalter 14 vorgesehen. Jedem Leistungsschalter 14 ist jeweils wieder eine durch einen Leiterbahnabschnitt der Leiterplatte 12 gebildete Sensezone 22 und ein Senseelement 18 zugeordnet. Im vorliegenden Fall sind also sowohl acht Sensezonen 22 bzw. Shunts als auch acht Senseelemente 18 vorgesehen. Den Leistungsschaltern 14 sind zudem jeweils wieder Mittel 50 zur Temperaturüberwachung bzw. für einen Übertemperatur-Schutz zugeordnet, die jeweils insbesondere wieder einen NTC-Widerstand 52 umfassen können. Für die hier beispielsweise acht Leistungsschalter 14 können insbesondere auch wieder diesen gemeinsame, u.a. beispielsweise nur einen NTC-Widerstand umfassende Mittel 24 zur Temperaturkompensation zugeordnet sein.

Besondere Layoutmaßnahmen können die umgebende Temperatur des Leistungsschalters 14 zum NTC-Widerstand 52 leiten, indem z.B. Kupferflächen 80 vorgesehen werden, die unterhalb des Leistungsschalters 14 in der angrenzenden Innenlage verlaufen und die Temperatur bis hin zum NTC-Widerstand 52 leiten. Der NTC-Widerstand 52 befindet sich bevorzugt auf der Außenlage oberhalb der Kupferflächen 80 in direkter Nähe zum Leistungsschalter 14 und wird elektrisch und thermisch über "Thermo Vias" mit den beiden Kupferflächen 80 verbunden.

In ähnlicher Weise kann die Temperatur der Sensezonen zum NTC-Widerstand 72 der Mittel zur Temperaturkompensation 24 geleitet werden, indem je zwei Kupferflächen auf den Außenlagen der Leiterplatte 12 über den Sensezonen verlaufen, die mit "Thermo Vias" 78 miteinander elektrisch und thermisch verbunden sein können, wobei der NTC-Widerstand 72 selbst auf eine der beiden Außenlagen auf die Kupferflächen gelötet sein kann.

Der Mikrocontroller 64 kann beispielsweise die Informationen der Steuer- und/oder Auswerteeinrichtung 20 bzw. der ASICs 62 auslesen und verarbeiten sowie Befehle wie z.B. Ein- und/oder Ausschaltbefehle übertragen. Dabei genügt ein solcher Mikroprozessor 64 für sämtliche Leistungsschalter 14.

Zudem ist in Fig. 3 wie auch bereits in der Fig. 1 wieder ein Laststecker 16 zu erkennen.

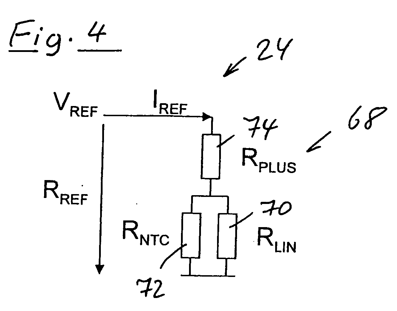

Wie sich aus Fig. 4 ergibt, können die Mittel 24 zur Temperaturkompensation beispielsweise einen Schaltkreis 68 zur Erzeugung eines Referenzstroms I_{REF} für die Strommessschaltung umfassen. Dabei kann dieser Schaltkreis 68 beispielsweise einen zu einem Widerstand 70 parallelen NTC-Widerstand 72 sowie einen zu der Parallelschaltung aus den beiden Widerständen 70, 72 in Reihe geschalteten Widerstand 74 umfassen.

Die Sensezonen 22 in den Innenlagen der Leiterplatte 12 können dicht beieinander liegen. Zweckmäßigerweise sind die Sensezonen 22 in den Außenlagen der Platine bzw. Leiterplatte von je zwei Kupferflächen überdeckt. Dabei können die oberen und unteren Kupferflächen mit Thermo Vias 80 verbunden sein. Der temperaturabhängige NTC-Widerstand 72 der Mittel zur Temperaturkompensation 24 kann an jeweils eine Kupferfläche 72 aufgelötet sein.

Ein NTC-Widerstand 52 kann zur Erfassung der umgebenden Temperatur des Leistungsschalters 14 sehr nahe am Leistungsschalter 14 positioniert sein. Er kann über zwei Kupferflächen 80 gelötet sein, die sowohl in der angrenzenden Innenlage unterhalb des Leistungsschalters 14 als auch unterhalb des NTC-Widerstandes 52 verlaufen können. Der NTC-Widerstand kann über Thermo Vias mit den Kupferflächen elektrisch verbunden werden.

### Bezugszeichenliste

- 10: Schaltungsanordnung
- 12: Leiterplatte
- 14: Leistungsschalter
- 16: Anschluss, Laststecker
- 18: Senseelement, Sensewiderstand
- 20: Steuer- und/oder Auswerteeinrichtung
- 22: Sensezone, Shunt
- 24: Mittel zur Temperaturkompensation
- 26: Knotenpunkt
- 28: erster Eingang
- 30: Differenzverstärker, Operationsverstärker
- 32: Knotenpunkt
- 34: zweiter Eingang
- 36: obere Schicht
- 38: innere Schicht
- 40: Ausgang
- 42: Last
- 44: Analog/Digital-Wandler
- 46: Logikschaltung
- 48: Multiplexer
- 50: Mittel zur Temperaturüberwachung
- 52: NTC-Widerstand
- 54: Komparator
- 56: Abschaltmittel
- 58: Treiber
- 60: Ladungspumpe
- 62: ASIC
- 64: Mikrocontroller
- 66: Energie- oder Spannungsversorgungsanschluss
- 68: Referenzstrom-Schaltkreis
- 70: Widerstand
- 72: NTC-Widerstand
- 74: Widerstand
- 76: Kupferflächen
- 78: Thermo Vias
- 80: Kupferflächen

- I_{L}: Laststrom
- I_{Sense}: Sensestrom
- I_{Shunt}: Shuntstrom, größerer Teil des Laststroms des Leistungsschalters
- I_{REF}: Referenzstrom
- S_{Temp}: Temperatursignal
- S_{Trip}: Abschaltpegel

## Patentansprüche

1. Schaltungsanordnung (10) mit wenigstens einem auf einer Leiterplatte (12) angeordneten Leistungsschalter (14), der an eine Last (42) anschließbar ist, einem Senseelement (18), durch das ein vom durch die Last (42) fließenden Laststrom (I_{L}) abhängiger Sensestrom (Isense) fließt, der einem kleineren Teil des Laststromes (I_{L}) entspricht, und einer Steuer- und/oder Auswerteeinrichtung (20) zur Erfassung des Sensestromes (I_{Sense}) und zur Ermittlung des Laststromes (I_{L}) in Abhängigkeit vom erfassten Sensestrom (Isense), wobei eine einen Leiterbahnabschnitt der Leiterplatte (12) umfassende Sensezone (22) vorgesehen ist, durch die der Laststrom (I_{L}) fließt, und der durch das Senseelement (18) fließende Strom mittels der Steuer- und/oder Auswerteeinrichtung (20) auf einen Wert geregelt wird, der in einem vorgebbaren Verhältnis zu dem in der Sensezone (22) fließenden Strom steht,
**dadurch gekennzeichnet,**
**dass** die Steuer- und/oder Auswerteeinrichtung (20) den Laststrom (I_{L}) anhand des erfassten Sensestromes (I_{Sense}) und eines Skalierungsfaktors ermittelt, der durch das Verhältnis des Widerstandes des Senseelements (18) zum Widerstand der Sensezone (22) bestimmt ist, und dass die Steuer- und/oder Auswerteeinrichtung (20) Mittel (24) umfasst, um bei der Ermittlung des Laststromes (I_{L}) sich aufgrund von Temperaturänderungen ergebende Änderungen des Skalierungsfaktors zu kompensieren.

2. Schaltungsanordnung nach Anspruch 1,
**dadurch gekennzeichnet,**
**dass** das Senseelement (18) einen Sensewiderstand umfasst.

3. Schaltungsanordnung nach Anspruch 1 oder 2,
**dadurch gekennzeichnet,**
**dass** die am Senseelement (18) abfallende Spannung mittels der Steuer- und/oder Auswerteeinrichtung (20) auf einen Wert geregelt wird, der der an der Sensezone (22) abfallenden Spannung entspricht.

4. Schaltungsanordnung nach einem der vorhergehenden Ansprüche,
**dadurch gekennzeichnet,**
**dass** die Mittel (24) zur Kompensation von sich aufgrund von Temperaturänderungen ergebenden Änderungen des Skalierungsfaktors einen NTC, negative temperature coefficient, -Widerstand umfassen.

5. Schaltungsanordnung nach einem der vorhergehenden Ansprüche,
**dadurch gekennzeichnet,**
**dass** das Senseelement (18) einen SMD , surface mounted device, Sensewiderstand umfasst.

6. Schaltungsanordnung nach einem der vorhergehenden Ansprüche,
**dadurch gekennzeichnet,**
**dass** die Steuer- und/oder Auswerteeinrichtung (20) zur Erfassung des Sensestromes (I_{Sense}) und zur Regelung der am Senseelement (18) abfallenden Spannung einen Differenzverstärker (30) umfasst.

7. Schaltungsanordnung nach einem der vorhergehenden Ansprüche,
**dadurch gekennzeichnet,**
**dass** die Steuer- und/oder Auswerteeinrichtung (20) zur Ermittlung des Laststromes (I_{L}) in Abhängigkeit vom erfassten Sensestrom einen Analog/ Digital-Wandler (44) und eine Logikschaltung (46) umfasst.

8. Schaltungsanordnung nach Anspruch 7,
**dadurch gekennzeichnet,**
**dass** mehreren Leistungsschaltern (14) ein gemeinsamer Analog/Digital-Wandler (44) und eine gemeinsame Logikschaltung (46) zugeordnet sind.

9. Schaltungsanordnung nach Anspruch 8,
**dadurch gekennzeichnet,**
**dass** die Steuer- und/oder Auswerteeinrichtung (20) für jeden Leistungsschalter (14) jeweils einen getrennten Differenzverstärker (30) umfasst und dass die Differenzverstärker (30) über einen Multiplexer (48) mit dem gemeinsamen Analog/Digital-Wandler (44) verbunden sind.

10. Schaltungsanordnung nach einem der Ansprüche 6 bis 9,
**dadurch gekennzeichnet,**
**dass** der Hauptstrompfad des Leistungsschalters (14), die Sensezone (22) und die Last (42) in Reihe zwischen zwei Versorgungsspannungsklemmen geschaltet sind, dass das Senseelement (18) einerseits mit dem höheren Potential der Sensezone (22) und andererseits mit einem ersten Eingang des zugeordneten Differenzverstärkers (30) verbunden ist und dass das niedrigere Potential der Sensezone (22) mit einem zweiten Eingang (34) des Differenzverstärkers (30) verbunden ist.

11. Schaltungsanordnung nach einem der vorhergehenden Ansprüche,
**dadurch gekennzeichnet,**
**dass** Mittel (50) zur Überwachung der im Bereich des Leistungsschalters (14) vorherrschenden Temperatur vorgesehen sind.

12. Schaltungsanordnung nach einem der vorhergehenden Ansprüche,
**dadurch gekennzeichnet,**
**dass** Mittel (56) vorgesehen sind, um den Leistungsschalter (14) abzuschalten, wenn der Laststrom (I_{L}) einen vorgebbaren maximal zulässigen Stromwert überschreitet und/oder die im Bereich des Leistungsschalters vorherrschende Temperatur einen vorgebbaren maximal zulässigen Temperaturwert überschreitet und/oder der Laststrom einen vorgebbaren, im Vergleich zum maximalen Stromwert kleineren Stromwert für eine vorgebbare Zeit überschreitet.

13. Schaltungsanordnung nach einem der vorhergehenden Ansprüche,
**dadurch gekennzeichnet,**
**dass** der Leistungsschalter (14) einen FET umfasst.

## Claims

1. A circuit arrangement (10) having at least one power switch (14) arranged on a printed circuit board (12) which is connectable to a load (42), a sense element (18) through which a sense current (I_{Sense}) dependent on a load current (I_{L}) flowing through the load (42) is flowing, corresponding to a smaller part of the load current (I_{L}), and a control and/or evaluation unit (20) for sensing the sense current (I_{Sense}) and for determining the load current (I_{L}) dependent on the detected sense current (I_{Sense}), wherein a sense zone (22) is provided comprising a conductor path section of the printed circuit board (12) through which the load current (I_{L}) is flowing, and wherein the current flowing through the sense element (18) is regulated by the control and/or evaluation unit (20) to a value which is in a predeterminable ratio to the current flowing in the sense zone (22),
**characterized in that**
the control and/or evaluation unit (20) detects the load current (I_{L}) on the basis of the detected sense current (I_{Sense}) and a scaling factor determined by the ratio of the resistance of the sense element (18) to the resistance of the sense zone (22), and that the control and/or evaluation unit (20) includes means (24) to compensate for changes of the scaling factor due to temperature changes in the determination of the load current (I_{L}).

2. A circuit arrangement according to claim 1,
**characterized in that**
the sense element (18) comprises a sense resistor.

3. A circuit arrangement according to claim 1 or 2,
**characterized in that**
the voltage drop at the sense element (18) is regulated by means of the control and/or evaluation unit (20) to a value corresponding to the voltage drop at the sense zone (22).

4. A circuit arrangement according to one of the preceding claims,
**characterized in that**
the means (24) for compensating for changes of the scaling factor due to temperature changes include a negative temperature coefficient (NTC) resistor.

5. A circuit arrangement according to one of the preceding claims,
**characterized in that**
the sense element (18) includes a surface mounted device (SMD) sense resistor.

6. A circuit arrangement according to one of the preceding claims,
**characterized in that**
the control and/or evaluation unit (20) includes a differential amplifier (30) for detecting the sense current (I_{Sense}) and for regulation of the voltage drop at the sense element (18).

7. A circuit arrangement according to one of the preceding claims,
**characterized in that**
the control and/or evaluation unit (20) includes an analog/digital converter (44) and a logic circuit (46) for determining the load current (I_{L}) dependent on the detected sense current.

8. A circuit arrangement according to claim 7,
**characterized in that**
a common analog/digital converter (44) and a common logic circuit (46) are associated with a plurality of power switches (14).

9. A circuit arrangement according to claim 8,
**characterized in that**
the control and/or evaluation unit (20) includes a separate differential amplifier (30) for each power switch (14), respectively, and that the differential amplifiers (30) are connected to the common analog/digital converter (44) via a multiplexer (48).

10. A circuit arrangement according to one of claims 6 to 9,
**characterized in that**
the main current path of the power switch (14), the sense zone (22) and the load (42) are connected in series between two supply voltage terminals, that the sense element (18) is connected on one side to the higher potential of the sense zone (22) and on the other side to a first input of the associated differential amplifier (30) and that the lower potential of the sense zone (22) is connected to a second input (34) of the differential amplifier (30).

11. A circuit arrangement according to one of the preceding claims,
**characterized in that**
means (50) are provided for monitoring the temperature prevailing in the area of the power switch (14).

12. A circuit arrangement according to one of the preceding claims,
**characterized in that**
means (56) are provided to turn off the power switch (14) when the load current (I_{L}) exceeds a predeterminable maximum permissible current value and/or the temperature prevailing in the area of the power switch exceeds a predeterminable maximum permissible temperature value and/or the load current exceeds, for a predeterminable time, a predeterminable current value, that is smaller compared to the maximum current value.

13. A circuit arrangement according to one of the preceding claims,
**characterized in that**
the power switch (14) comprises a FET.

## Revendications

1. Agencement de circuit (10) comprenant au moins un commutateur de puissance (14) qui est agencé sur une carte à circuits (12) et qui peut être branché à une charge (42), comprenant un élément capteur (18) à travers lequel s'écoule un courant de capteur (I_{Sense}) dépendant du courant de charge (I_{L}) s'écoulant à travers la charge (42) et correspondant à une petite partie du courant de charge (IL), et comprenant une unité de commande et/ou d'évaluation (20) pour détecter le courant de capteur (I_{Sense}) et pour déterminer le courant de charge (I_{L}) en fonction du courant de capteur détecté (I_{Sense}), dans lequel il est prévu une zone de capteur (22) incluant une portion de piste conductrice de la carte à circuits (12) à travers laquelle s'écoule le courant de charge (IL), et le courant qui s'écoule à travers l'élément capteur (18) est régulé, au moyen de l'unité de commande et/ou d'évaluation (20) à une valeur qui se trouve dans une relation prédéterminée par rapport au courant s'écoulant dans la zone de capteur (22),
**caractérisé en ce que**
l'unité de commande et/ou d'évaluation (20) détermine le courant de charge (I_{L}) au moyen du courant de capteur détecté (I_{Sense}) et d'un facteur d'échelle qui est déterminé par le rapport de la résistance de l'élément capteur (18) sur la résistance de la zone de capteur (22), et **en ce que** l'unité de commande et/ou d'évaluation (20) inclut des moyens (24) afin de compenser, lors de la détermination du courant de charge (I_{L}), des variations du facteur d'échelle qui se produisent en raison de variations de température.

2. Agencement de circuit selon la revendication 1,
**caractérisé en ce que** l'élément capteur (18) inclut une résistance de capteur.

3. Agencement de circuit selon la revendication 1 ou 2,
**caractérisé en ce que** la tension qui chute au niveau de l'élément capteur (18) est régulée au moyen de l'unité de commande et/ou d'évaluation (20) à une valeur qui correspond à la tension qui chute au niveau de la zone de capteur (22).

4. Agencement de circuit selon l'une des revendications précédentes,
**caractérisé en ce que** les moyens (24) pour la compensation de variation du facteur d'échelle qui se produisent en raison de variations de température incluent une résistance NTC (à coefficient de température négatif).

5. Agencement de circuit selon l'une des revendications précédentes,
**caractérisé en ce que** l'élément capteur (18) inclut une résistance de capteur du type SMD (surface mounted device, ou "dispositif monté en surface").

6. Agencement de circuit selon l'une des revendications précédentes,
**caractérisé en ce que** l'unité de commande et/ou d'évaluation inclut un amplificateur différentiel (30) pour détecter le courant de capteur (I_{Sense}) et pour réguler la tension qui chute au niveau de l'élément capteur (18).

7. Agencement de circuit selon l'une des revendications précédentes,
**caractérisé en ce que** l'unité de commande et/ou d'évaluation (20) inclut un convertisseur analogique/numérique (44) et un circuit logique (46) pour la détermination du courant de charge (I_{L}) en fonction du courant de capteur détecté.

8. Agencement de circuit selon la revendication 7,
**caractérisé en ce qu'**un convertisseur analogique/numérique (44) commun et un circuit logique (46) commun sont associés à plusieurs commutateurs de puissance (14).

9. Agencement de circuit selon la revendication 8,
**caractérisé en ce que** l'unité de commande et/ou d'évaluation (20) inclut un amplificateur différentiel séparé (30) respectif pour chaque commutateur de puissance (14), et **en ce que** les amplificateurs différentiels (30) sont reliés au convertisseur analogique/numérique (44) commun via un multiplexeur (48).

10. Agencement de circuit selon l'une des revendications 6 à 9,
**caractérisé en ce que** le trajet de courant principal du commutateur de puissance (14), la zone de capteur (22) et la charge (42) sont branchés en série entre deux bornes de tension d'alimentation, **en ce que** l'élément capteur (18) d'une part est connecté avec le potentiel plus élevé de la zone de capteur (22) et d'autre part avec une première entrée de l'amplificateur différentiel associé (30), et **en ce que** le potentiel plus faible de la zone de capteur (22) est connecté avec une seconde entrée (34) de l'amplificateur différentiel (30).

11. Agencement de circuit selon l'une des revendications précédentes,
**caractérisé en ce qu'**il est prévu des moyens (50) pour surveiller la température qui règne dans la région du commutateur de puissance (14).

12. Agencement de circuit selon l'une des revendications précédentes,
**caractérisé en ce qu'**il est prévu des moyens (56) afin de couper le commutateur de puissance (14) quand le courant de charge (I_{L}) dépasse une valeur de courant admissible maximale prédéterminée, et/ou quand la température qui règne dans la région du commutateur de puissance dépasse une valeur de température admissible maximale prédéterminée et/ou quand le courant de charge dépasse pendant un temps prédéterminé une valeur de courant prédéterminée plus faible par comparaison à la valeur de courant maximale.

13. Agencement de circuit selon l'une des revendications précédentes,
**caractérisé en ce que** le commutateur de puissance (14) inclut un transistor à effet de champ FET.
